# EUROPEAN PATENT APPLICATION

(11) **EP 4 607 316 A1**
(43) Date of publication of application: **27.08.2025**
(21) Application number: 25153076.2
(22) Date of filing: 21.01.2025
(51) Int. Cl.: G06F 1/16, G09F 9/30, H04M 1/02

(54) **DISPLAY DEVICE**

(30) Priority: 23.02.2024 KR 20240026736
(71) Applicant: Samsung Display Co., Ltd., Yongin-si, Gyeonggi-do 17113 (KR)
(72) Inventor: RYU, Suchang, 17113 Yongin-si (KR); CHO, Sungwoo, 17113 Yongin-si (KR); KIM, Gyutae, 17113 Yongin-si (KR); AN, Sungguk, 17113 Yongin-si (KR); CHOI, Jung Kyu, 17113 Yongin-si (KR)
(74) Representative: Walaski, Jan Filip

(57) **Abstract**

A display device includes a display panel, a support member under the display panel and including a lattice portion with at least one opening defined, a first lower adhesive layer between the display panel and the support member and overlapping the flat area, a cover adhesive layer between the display panel and the support member and overlapping the folding area, and a cover member between the display panel and the support member, overlapping the folding area, and adhered to the cover adhesive layer.

## Description

### BACKGROUND

### 1. Field

The present disclosure relates generally to a display device.

### 2. Description of the Related Art

Flat panel displays (e.g., organic light emitting display devices) may be relatively light in weight and thin. As technology advances, the development of flexible display devices with flexible characteristics is increasing. A flexible display device may include a curved display device, a bent display device, a foldable display device, a rollable display device, and a stretchable display device.

A flexible display device may include a display panel and a protective film. The display panel may have flexible characteristics, and the protective film may be located under the display panel and support the display panel.

The above information disclosed in this Background section is only for enhancement of understanding of the background and therefore the information discussed in this Background section does not necessarily constitute prior art.

### SUMMARY

Aspects of some embodiments include a display device.

A display device according to some embodiments may include a display panel divided into a folding area and a flat area adjacent to the folding area, a support member under the display panel and including a lattice portion with at least one opening defined, a first lower adhesive layer between the display panel and the support member and overlapping the flat area, a cover adhesive layer between the display panel and the support member and overlapping the folding area, and a cover member between the display panel and the support member, overlapping the folding area, and adhered to the cover adhesive layer.

According to some embodiments, the cover member may cover the lattice portion.

According to some embodiments, a length of the cover member may be greater than a length of the lattice portion.

According to some embodiments, the cover member may be spaced apart from the display panel.

According to some embodiments, a sum of a thickness of the cover adhesive layer and a thickness of the cover member may be smaller than a thickness of the first lower adhesive layer.

According to some embodiments, the thickness of the first lower adhesive layer may be in a range of 25 micrometers (µm) to 50 µm (or about 25 µm to about 50 µm).

According to some embodiments, the cover member may include a metal.

According to some embodiments, the cover member may include stainless steel (SUS).

According to some embodiments, the cover member may include a fiber reinforced plastic (FRP).

According to some embodiments, the display device may further include a digitizer under the support member.

According to some embodiments, the cover adhesive layer may be spaced apart from the first lower adhesive layer.

According to some embodiments, the first lower adhesive layer may contact the display panel.

According to some embodiments, a modulus of the first lower adhesive layer may be different from a modulus of the cover adhesive layer.

According to some embodiments, the support member may further include a resin filled in the opening.

According to some embodiments, the cover adhesive layer may further overlap the flat area and may be under the first lower adhesive layer.

According to some embodiments, the cover adhesive layer may further overlap the flat area and may be on the first lower adhesive layer.

Therefore, a display device according to some embodiments of the present invention may include a cover member that covers the lattice portion of the support member. The lattice portion may be formed in a folding area, and the cover member may have a width greater than a width of the lattice portion on the upper surface of the lattice portion. Accordingly, the stress applied to the grid portion while the display device is folded may be relatively reduced, impact resistance characteristics in the folding area may be relatively improved, and a crease in the folding area may be prevented or reduced.

### BRIEF DESCRIPTION OF THE DRAWINGS

The accompanying drawings, which are included to provide a further understanding of embodiments according to the present disclosure and are incorporated in and constitute a part of this specification, illustrate aspects of some embodiments of the present disclosure together with the description.
FIGS. 1 and 2 are perspective views illustrating a display device according to some embodiments of the present invention.
FIG. 3 is a cross-sectional view illustrating the display device of FIG. 1.
FIG. 4 is a plan view illustrating a support member included in the display device of FIG. 3.
FIG. 5 is an enlarged view of the area A of FIG. 3.
FIG. 6 is a cross-sectional view illustrating a display device according to some embodiments of the present invention.
FIG. 7 is a cross-sectional view illustrating a display device according to some embodiments of the present invention.
FIG. 8 is a cross-sectional view illustrating a display device according to a comparative example of the present invention.
FIG. 9 is a cross-sectional view illustrating a display device according to another comparative example of the present invention.
FIG. 10 is a graph illustrating crease measurement results according to comparative examples and embodiments of the present invention.
FIG. 11 is a cross-sectional view illustrating a display device according to some embodiments of the present invention.
FIG. 12 is a plan view illustrating a support member included in a display device according to some embodiments of the present invention.
FIG. 13 is a cross-sectional view illustrating a display device according to some embodiments of the present invention.
FIG. 14 is an enlarged view of the area B of FIG. 13.
FIG. 15 is a cross-sectional view illustrating a display device according to some embodiments of the present invention.
FIG. 16 is an enlarged view of the area C of FIG. 15.

### DETAILED DESCRIPTION

Illustrative, non-limiting embodiments will be more clearly understood from the following detailed description in conjunction with the accompanying drawings.

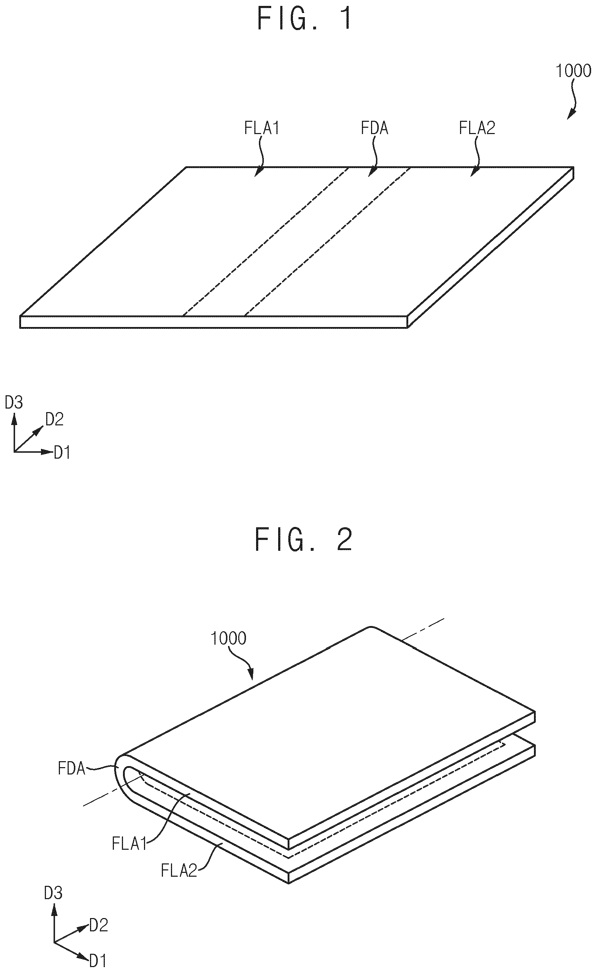

FIGS. 1 and 2 are perspective views illustrating a display device according to some embodiments of the present invention.

Referring to FIGS. 1 and 2, a display device 1000 may be divided into at least one folding area and at least one flat area. For example, the display device 1000 may be divided into a folding area FDA, a first flat area FLA1, and a second flat area FLA2. The display device 1000 may display images in the folding area FDA, the first flat area FLA1, and the second flat area FLA2. In this case, the display device 1000 may have a display surface defined by a first direction D1 and a second direction D2 and a thickness defined by a third direction D3.

The display device 1000 may be folded in the folding area FDA. For example, the display device 1000 may be in-folded (folded inwards) or out-folded (folded outwards) in the folding area FDA without damaging the display device 1000.

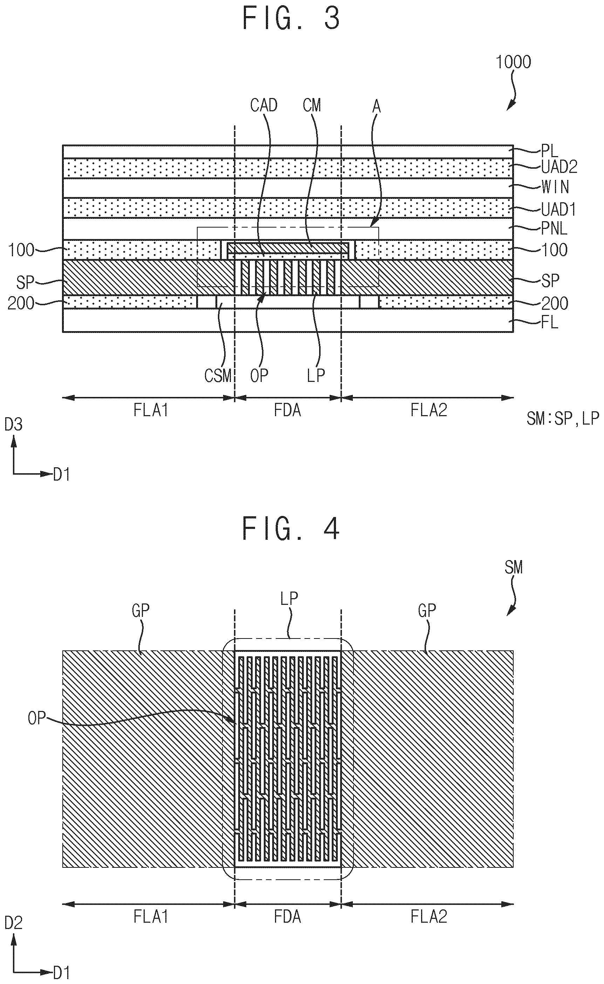

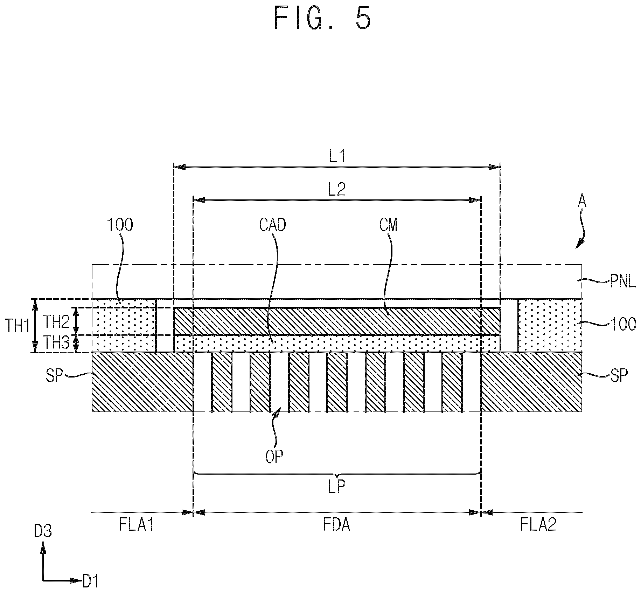

FIG. 3 is a cross-sectional view illustrating the display device of FIG. 1. FIG. 4 is a plan view illustrating a support member included in the display device of FIG. 3. FIG. 5 is an enlarged view of the area A of FIG. 3.

Referring to FIG. 3, the display device 1000 may include a display panel PNL, a support member SM, a first lower adhesive layer 100, a cover member CM, a cover adhesive layer CAD, a second lower adhesive layer 200, a cushioning member CSM, a functional layer FL, a first upper adhesive layer UAD1, a window WIN, a second upper adhesive layer UAD2, and a protective layer PL. The support member SM may include a support portion SP and a lattice portion LP.

The display panel PNL may overlap the folding area FDA, the first flat area FLA1, and the second flat area FLA2. The display panel PNL may display images in the folding area FDA, the first flat area FLA1, and the second flat area FLA2, and may be folded in the folding area FDA.

Referring to FIGS. 3 and 4, the support member SM may be located under the display panel PNL. The support member SM may include at least one of fiber reinforced plastics (FRP), metal, plastic, non-metal, and/or glass. Examples of fiber reinforced plastic that can be used as the support member SM may include glass fiber reinforced plastics (GFRP), carbon fiber reinforced plastic (CFRP), etc. Glass fiber reinforced plastic may be a material that combines aromatic nylon fibers such as glass fiber and thermosetting resins such as unsaturated polyester and epoxy resin, and carbon fiber reinforced plastic may be a material that combines aromatic nylon fibers such as carbon fiber and thermosetting resins. Examples of metals that can be used as the support member SM may include invar which is an alloy of nickel (Ni) and iron (Fe), stainless steel (SUS), titanium (Ti), and copper (Cu). Examples of plastics that can be used as the support member SM may be polyimide, polyethylene, polyethylene terephthalate, etc.

The support member SM may include the support portion SP and the lattice portion LP. The support portion SP may overlap the first and second flat areas FLA1 and FLA2, and the lattice portion LP may overlap the folding area FDA. At least one opening OP may be defined in the lattice portion LP, and the opening OP may penetrate the support member SM in the thickness direction. As the opening OP penetrates the support member SM, the support member SM may be smoothly folded. Accordingly, the display device 1000 may be relatively smoothly folded.

As shown in FIG. 4, the openings OP may be formed to intersect each other.

Referring again to FIG. 3, the first lower adhesive layer 100 may be located between the display panel PNL and the support member SM, and may overlap the first and second flat areas FLA1 and FLA2).

The first lower adhesive layer 100 may contact the display panel PNL and the support member SM and may adhere the display panel PNL and the support member SM to each other. In other words, the display device 1000 may not include a conventional protective film (e.g., a protective film located under the display panel).

The first lower adhesive layer 100 may include at least one of a pressure sensitive adhesive (PSA), an optically clear adhesive (OCA), or an optically clear adhesive resin (OCR).

A modulus of the first lower adhesive layer 100 (for example, the Young's modulus) may be set according to the folding characteristics of the display device 1000. For example, the modulus of the first lower adhesive layer 100 may be smaller than about 1.2 MPa at low temperature (e.g., about -20°C). Accordingly, the position of the neutral plane of the display device 1000 that does not include a conventional protective film may be appropriately adjusted.

The cover member CM may be located between the display panel PNL and the support member SM and may overlap the folding area FDA. The cover member CM may include at least one of fiber reinforced plastics (FRP), metal, plastic, non-metal, and/or glass. Examples of fiber reinforced plastic that can be used as the cover member CM may include glass fiber reinforced plastics (GFRP), carbon fiber reinforced plastic (CFRP), etc. Glass fiber reinforced plastic may be a material that combines aromatic nylon fibers such as glass fiber and thermosetting resins such as unsaturated polyester and epoxy resin, and carbon fiber reinforced plastic may be a material that combines aromatic nylon fibers such as carbon fiber and thermosetting resins. Examples of metals that can be used as the cover member CM may include invar which is an alloy of nickel (Ni) and iron (Fe), stainless steel (SUS), titanium (Ti), and copper (Cu). Examples of plastics that can be used as the cover member (CM) may be polyimide, polyethylene, polyethylene terephthalate, etc.

The cover adhesive layer CAD may be located between the display panel PNL and the support member SM, and may overlap the folding area FDA.

The cover adhesive layer CAD may contact the cover member CM and the support member SM, and may adhere the cover member CM and the support member SM to each other.

The cover adhesive layer CAD may include at least one of pressure sensitive adhesive (PSA), optically clear adhesive (OCA), or optically clear adhesive resin (OCR).

The cover adhesive layer CAD may be spaced apart from the first lower adhesive layer 100. In addition, a modulus (e.g. Young's modulus) of the cover adhesive layer CAD may be different from a modulus of the first lower adhesive layer 100.

Referring to FIG. 5, the cover member CM and the cover adhesive layer CAD may cover the lattice portion LP. In detail, the cover member CM may cover the opening OP defined in the lattice portion LP. For example, the cover member CM may have a first length L1 in the first direction D1, and the lattice portion LP may have a second length L2 in the first direction D1. In this case, the first length L1 may be greater than the second length L2 by about 600 µm. For example, the first length L1 may be about 10 mm to 12 mm, and the second length L2 may be about 9 mm to 10 mm.

The first lower adhesive layer 100 may have a first thickness TH1 in the third direction D3, the cover member CM may have a second thickness TH2 in the third direction D3, and the cover adhesive layer CAD may have a third thickness TH3 in the third direction D3. For example, the first thickness TH1 may be about 25 µm to 50 µm, and the third thickness TH3 may be greater than about 8 µm. The second thickness TH2 may be smaller than 15 µm (or about 15 µm) when the cover member CM is made of metal, and may be smaller than 35 µm (or about 35 µm) when the cover member CM is made of fiber-reinforced plastic. In this case, the sum of the second thickness TH2 and the third thickness TH3 may be smaller than the first thickness TH1. Accordingly, the cover member CM may be spaced apart from the display panel PNL.

Referring again to FIG. 3, the second lower adhesive layer 200 may be located under the support member SM and may overlap the first and second flat areas FLA1 and FLA2. The second lower adhesive layer 200 may include at least one of a pressure sensitive adhesive (PSA), an optically clear adhesive (OCA), or an optically clear adhesive resin (OCR).

The cushioning member (CSM) may be located under the support member SM and may overlap the folding area FDA. The cushioning member CSM may include flexible plastic materials such as thermoplastic polyurethane (TPU), polyimide, polyethylene terephthalate, latex, polyurethane foam, polystyrene foam, etc.

The functional layer FL may be located under the second lower adhesive layer 200. The functional layer FL may be a digitizer that detects electromagnetic changes caused by the approach of a pen. In this case, the cover member CM may be implemented with fiber-reinforced plastic. Accordingly, the operation of the functional layer FL may not be interrupted.

The display device 1000 may not include the functional layer FL. In this case, the cover member CM may be implemented with metal or fiber-reinforced plastic.

The first upper adhesive layer UAD1 may be located on the display panel PNL and may overlap the folding area FDA, the first flat area FLA1, and the second flat area FLA2. The first upper adhesive layer UAD1 may include at least one of pressure sensitive adhesive (PSA), optically clear adhesive (OCA), or optically clear adhesive resin (OCR).

The window WIN may be located on the first upper adhesive layer UAD1. The window WIN may be a front of the display device 1000 and may protect the display panel PNL (e.g., from external contaminants or from damage caused by impacts by external objects or surfaces). The window WIN may include ultra thin glass (UTG), polymethyl methacrylate (PMMA), polyethylene terephthalate (PET), etc.

The second upper adhesive layer UAD2 may be located on the window WIN and may overlap the folding area FDA, the first flat area FLA1, and the second flat area FLA2. The second upper adhesive layer UAD2 may include at least one of pressure sensitive adhesive (PSA), optically clear adhesive (OCA), or optically clear adhesive resin (OCR).

The protective layer PL may be located on the second upper adhesive layer UAD2. The protective layer PL may include a hard coating layer, an anti-reflection layer, an anti-fingerprint layer, etc. The hard coating layer may include at least one of urethane-based resin, epoxy-based resin, acrylic resin, or acrylate-based resin. The anti-reflection layer may relatively reduce the reflectance of the display device 1000 through a difference in refractive index. The anti-fingerprint layer may be formed by coating an anti-fingerprint material.

The display device 1000 may include a cover member CM that covers the lattice portion LP of the support member SM. The lattice portion LP may be formed in the folding area FDA, and the cover member CM may have a width greater than a width of the lattice portion LP on the upper surface of the lattice portion LP. Accordingly, the stress applied to the lattice portion LP while the display device 1000 is folded may be relatively reduced, the impact resistance characteristics in the folding area FDA may be relatively improved, and the crease in the folding area FDA may be prevented or reduced.

Further details of embodiments according to the present invention will be described below through specific embodiments and comparative examples.

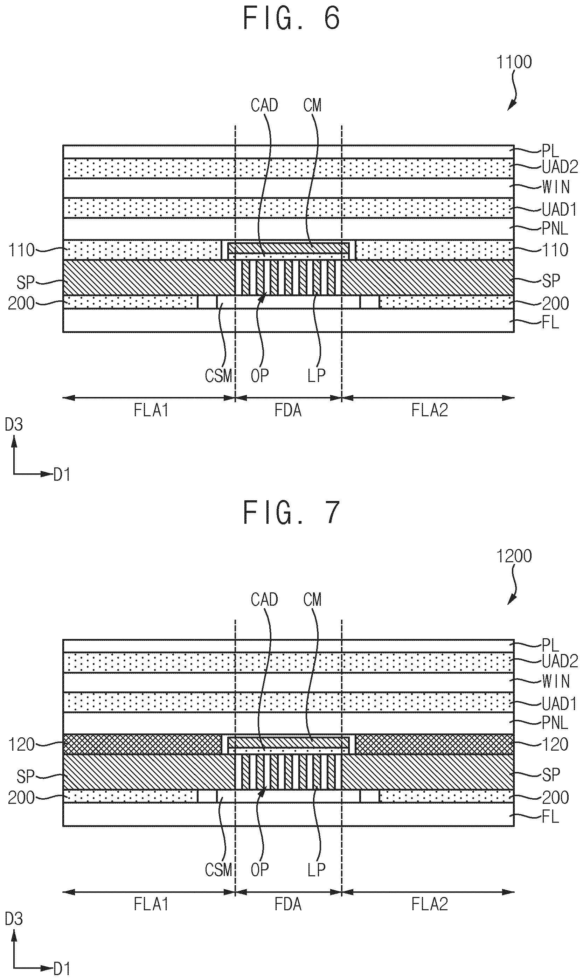

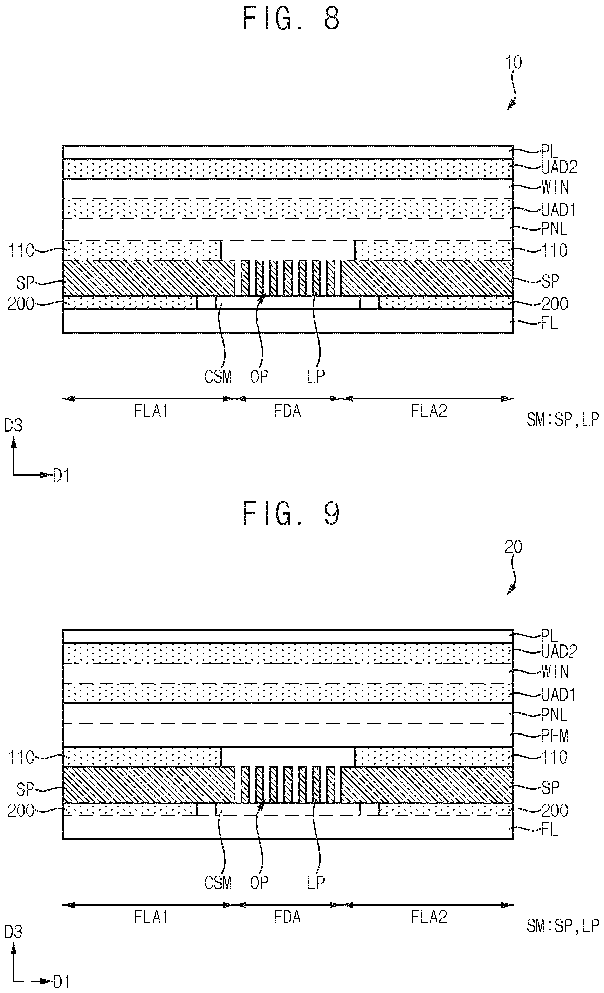

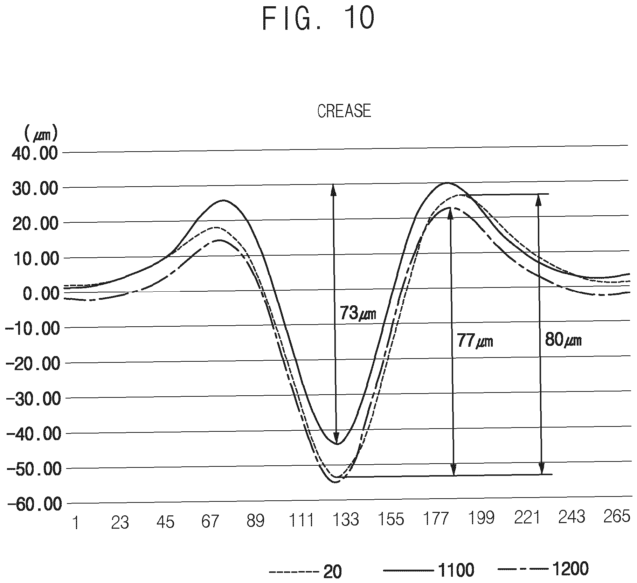

FIG. 6 is a cross-sectional view illustrating a display device according to some embodiments of the present invention. FIG. 7 is a cross-sectional view illustrating a display device according to some embodiments of the present invention. FIG. 8 is a cross-sectional view illustrating a display device according to a comparative example of the present invention. FIG. 9 is a cross-sectional view illustrating a display device according to another comparative example of the present invention. FIG. 10 is a graph illustrating crease measurement results according to comparative examples and embodiments of the present invention.

Referring to FIG. 6, a display device 1100 includes a first lower adhesive layer 110, a cover member CM, and a cover adhesive layer CAD. The modulus (for example Young's modulus) of the first lower adhesive layer 110 is 0.6 MPa (or about 0.6 MPa), and the thickness is 25 µm (or about 25 µm). The cover member CM is made of stainless steel (SUS), and the cover adhesive layer CAD is made of pressure sensitive adhesive (PSA).

In the display device 1100, the pen-drop height at which a bright spot occurred in the flat area was about 6 cm, and the pen-drop height at which a bright spot occurred in the folding area was about 10 cm. In addition, the ball-drop height at which the bright spot occurred in the flat area was about 5 cm, and the ball-drop height at which the bright spot occurred at the folding area was about 3 cm.

Referring to FIG. 7, a display device 1200 includes a first lower adhesive layer 120, a cover member CM, and a cover adhesive layer CAD. The modulus (for example Young's modulus) of the first lower adhesive layer 120 is 0.34 MPa (or about 0.34 MPa), and the thickness is 32 µm (or about 32 µm). The cover member CM and the cover adhesive layer CAD are substantially the same as the cover member CM and the cover adhesive layer CAD included in the display device 1100, respectively.

In the display device 1200, the pen-drop height at which a bright spot occurred in the flat area was about 13 cm, and the pen-drop height at which a bright spot occurred in the folding area was about 10 cm. In addition, the ball-drop height at which the bright spot occurred in the flat area was about 27 cm, and the ball-drop height at which the bright spot occurred at the folding area was about 2 cm.

Referring to FIG. 8, the display device 10 according to a comparative example of the present invention includes the first lower adhesive layer 110 and does not include the cover member CM and the cover adhesive layer CAD.

In the display device 10, the pen-drop height at which a bright spot occurs in the folding area was about 1 cm. In addition, the ball-drop height at which the bright spot occurs in the flat area was about 7cm.

Referring to FIG. 9, a display device 20 according to another comparative example of the present invention includes the first lower adhesive layer 110 and a protective film PFM. The protective film PFM is located under the display panel PNL and has a thickness of about 50 µm.

In the display device 20, the pen-drop height at which a bright spot occurred in the flat area was about 7 cm, and the pen-drop height at which a bright spot occurred in the folding area was about 6 cm. In addition, the ball-drop height at which the bright spot occurred in the flat area was about 5 cm, and the ball-drop height at which the bright spot occurred at the folding area was about 2 cm.

The pen-drop height and ball-drop height at which bright spots occur in the display devices 1100 and 1200 according to the embodiments of the present invention are greater than the pen-drop height and ball-drop height at which bright spots occur in the display device 10 and 20. In other words, the display devices 1100 and 1200 according to embodiments of the present invention, despite not including a separate protective film PFM, have impact resistance properties through the modulus and thickness of the first lower adhesive layer and the cover member.

Referring to FIG. 10, the crease measurement results of display devices according to comparative examples and embodiments are shown in a graph. In the case of the display device 20, a crease was formed with a depth of about 80 µm, in the case of the display device 1100, a crease was formed with a depth of about 73 µm, and in the case of the display device 1200, a crease was formed with a depth of about 77 µm. In other words, compared to the display device 20 including the protective film PFM, the depths of the crease formed in the display devices 1100 and 1200 including the cover member CM were smaller, and the folding characteristics were improved.

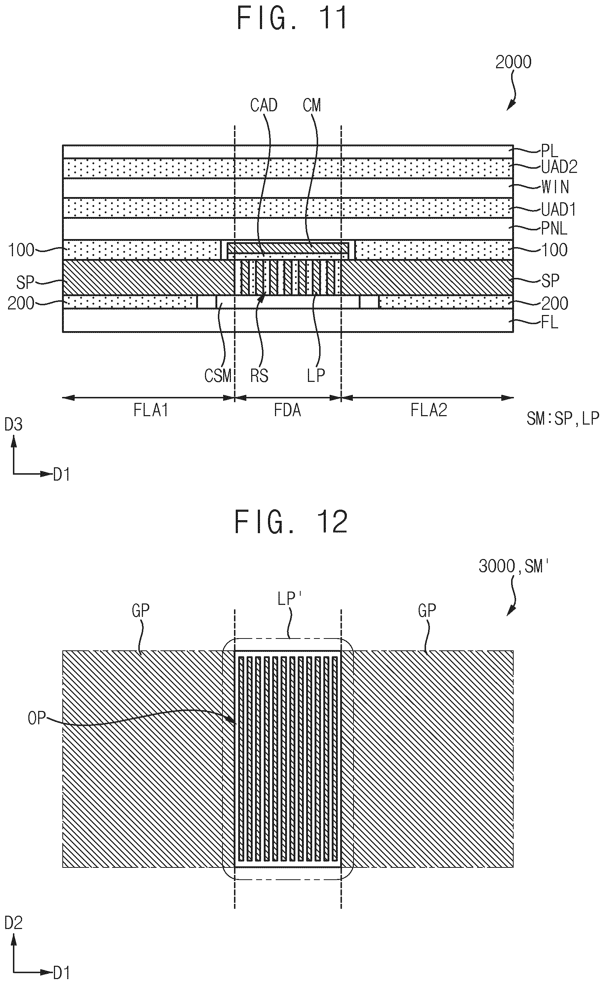

FIG. 11 is a cross-sectional view illustrating a display device.

Referring to FIG. 11, a display device 2000 may include a display panel PNL, a support member SM, a first lower adhesive layer 100, a cover member CM, a cover adhesive layer CAD, a second lower adhesive layer 200, a cushioning member CSM, a functional layer FL, a first upper adhesive layer UAD1, a window WIN, a second upper adhesive layer UAD2, and a protective layer PL. The support member SM may include a support portion SP, a lattice portion LP, and a resin RS.

The display device 2000 may be substantially the same as the display device 1000 described with reference to FIG. 3, except for the resin RS included in the support member SM.

The support member SM may be located under the first lower adhesive layer 100 and may include the support portion SP, the lattice portion LP, and the resin RS. The support portion SP may overlap the first and second flat areas FLA1 and FLA2, and the lattice portion LP and the resin RS may overlap the folding area FA.

At least one opening may be formed in the lattice portion LP, and the resin RS may be filled in the opening. As the resin RS fills the opening, deformation of the lattice portion LP may be relatively reduced.

In addition, the cover adhesive layer CAD and the cover member CM may be located on the resin RS. Accordingly, the cover adhesive layer CAD and the cover member CM may perform a masking role while the resin RS is formed, and the resin RS may be filled more precisely.

FIG. 12 is a plan view illustrating a support member included in a display device.

Referring to FIG. 12, a display device 3000 may be substantially the same as the display device 1000 described with reference to FIG. 3, except for a support member S M'.

The support member SM' may include a support portion SP and a lattice portion LP'. The support portion SP may overlap the first and second flat areas FLA1 and FLA2. The lattice portion LP' may overlap the folding area FDA. At least one opening OP may be defined in the lattice portion LP', and the opening OP may be formed in a slit shape as shown in FIG. 12.

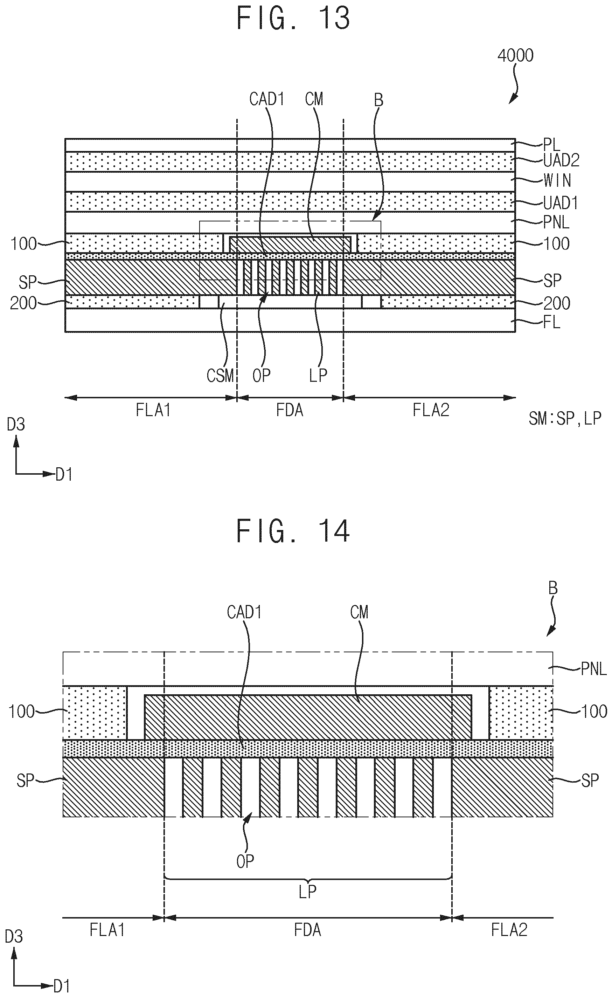

FIG. 13 is a cross-sectional view illustrating a display device. FIG. 14 is an enlarged view of the area B of FIG. 13.

Referring to FIGS. 13 and 14, a display device 4000 may include a display panel PNL, a support member SM, a first lower adhesive layer 100, a cover member CM, a cover adhesive layer CAD1, a second lower adhesive layer 200, a cushioning member CSM, a functional layer FL, a first upper adhesive layer UAD1, a window WIN, a second upper adhesive layer UAD2, and a protective layer PL. The support member SM may include a support portion SP and a lattice portion LP.

The display device 4000 may be substantially the same as the display device 1000 described with reference to FIG. 3, except for the first lower adhesive layer 100 and the cover adhesive layer CAD1.

The first lower adhesive layer 100 may be located under the display panel PNL and may overlap the first and second flat areas FLA1 and FLA2. The first lower adhesive layer 100 may contact the display panel PNL. The first lower adhesive layer 100 may include at least one of pressure sensitive adhesive (PSA), optically clear adhesive (OCA), or optically clear adhesive resin (OCR).

The cover adhesive layer CAD1 may be located under the first lower adhesive layer 100, and may overlap the folding area FDA, the first flat area FLA1, and the second flat area FLA2. The cover adhesive layer CAD1 may contact the first lower adhesive layer 100, the cover member CM, and the support member SM. The cover adhesive layer CAD1 may include at least one of pressure sensitive adhesive (PSA), optically clear adhesive (OCA), or optically clear adhesive resin (OCR).

The material of the first lower adhesive layer 100 and the material of the cover adhesive layer CAD1 may be different from each other. For example, the modulus of the first lower adhesive layer 100 and the modulus of the cover adhesive layer CAD1 may be different from each other. The material of the first lower adhesive layer 100 and the material of the cover adhesive layer CAD1 may be the same.

The sum of the thicknesses of the first lower adhesive layer 100 and the cover adhesive layer CAD1 may be in a range of 25 µm to 50 µm (or about 25 µm to 50 µm). In addition, the sum of the thickness of the cover adhesive layer CAD1 and the thickness of the cover member CM may be smaller than the thickness of the first lower adhesive layer 100.

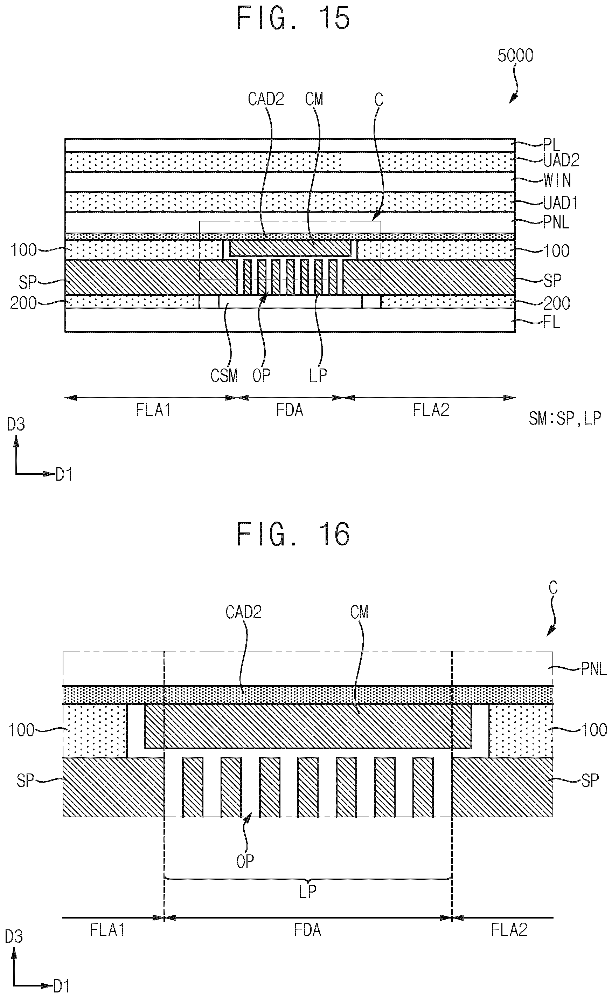

FIG. 15 is a cross-sectional view illustrating a display device. FIG. 16 is an enlarged view of the area C of FIG. 15.

Referring to FIGS. 15 and 16, a display device 5000 may include a display panel PNL, a support member SM, a first lower adhesive layer 100, a cover member CM, a cover adhesive layer CAD2, a second lower adhesive layer 200, a cushioning member CSM, a functional layer FL, a first upper adhesive layer UAD1, a window WIN, a second upper adhesive layer UAD2, and a protective layer PL. The support member SM may include a support portion SP and a lattice portion LP.

The display device 5000 may be substantially the same as the display device 1000 described with reference to FIG. 3, except for the first lower adhesive layer 100 and the cover adhesive layer CAD2.

The first lower adhesive layer 100 may be located on the support member SM and may overlap the first and second flat areas FLA1 and FLA2. The first lower adhesive layer 100 may contact the support member SM. The first lower adhesive layer 100 may include at least one of pressure sensitive adhesive (PSA), optically clear adhesive (OCA), or optically clear adhesive resin (OCR).

The cover adhesive layer CAD2 may be located on the first lower adhesive layer 100, and may overlap the folding area FDA, the first flat area FLA1, and the second flat area FLA2. The cover adhesive layer CAD2 may contact the first lower adhesive layer 100, the cover member CM, and the display panel PNL. The cover adhesive layer CAD2 may include at least one of pressure sensitive adhesive (PSA), optically clear adhesive (OCA), or optically clear adhesive resin (OCR).

The material of the first lower adhesive layer 100 and the material of the cover adhesive layer CAD2 may be different from each other. For example, the modulus (e.g Young's modulus) of the first lower adhesive layer 100 and the modulus (e.g. Young's modulus) of the cover adhesive layer CAD2 may be different from each other. The material of the first lower adhesive layer 100 and the material of the cover adhesive layer CAD2 may be the same.

The sum of the thicknesses of the first lower adhesive layer 100 and the cover adhesive layer CAD2 may be about 25 µm to 50 µm. In addition, the sum of the thickness of the cover adhesive layer CAD2 and the thickness of the cover member CM may be smaller than the thickness of the first lower adhesive layer 100.

A display device may include a cover member that covers the lattice portion of the support member. The lattice portion may be formed in a folding area, and the cover member may have the width greater than the width of the lattice portion on the upper surface of the lattice portion. Accordingly, the stress applied to the lattice portion while the display device is folded may be relatively reduced, impact resistance characteristics in the folding area may be relatively improved, and crease in the folding area may be prevented or reduced.

Although certain embodiments and implementations have been described herein, other embodiments and modifications will be apparent from this description. Accordingly, the inventive concepts are not limited to such embodiments, but rather to the scope of the invention as defined by the appended claims.

## Claims

1. A display device comprising:
a display panel (PNL) divided into a folding area (FDA) and a flat area (FLA1, FLA2) adjacent to the folding area;
a support member (SM, SM') under the display panel and including a lattice portion (LP, LP') with at least one opening;
a first lower adhesive layer (100, 110, 120) between the display panel and the support member (SM) and overlapping the flat area;
a cover adhesive layer (CAD, CAD1, CAD2) between the display panel (PNL) and the support member (SM, SM') and overlapping the folding area (FDA); and
a cover member (CM) between the display panel (PNL) and the support member (SM), overlapping the folding area, and adhered to the cover adhesive layer.

2. The display device of claim 1, wherein the cover member covers the lattice portion.

3. The display device of claim 2, wherein the cover member is longer than the lattice portion.

4. The display device of any one of the preceding claims, wherein the cover member is spaced apart from the display panel.

5. The display device of any one of the preceding claims, wherein the sum of the thicknesses of the cover adhesive layer and the cover member is less than the thickness of the first lower adhesive layer.

6. The display device of claim 5, wherein the thickness of the first lower adhesive layer is in the range of 25 micrometers (µm) to 50 µm.

7. The display device of any one of the preceding claims, wherein the cover member includes a metal.

8. The display device of claim 7, wherein the cover member includes stainless steel (SUS).

9. The display device of any one of the preceding claims, wherein the cover member includes a fiber reinforced plastic (FRP).

10. The display device of claim 9, further comprising:
a digitizer under the support member.

11. The display device of any one of the preceding claims, wherein the cover adhesive layer is spaced apart from the first lower adhesive layer.

12. The display device of any one of the preceding claims, wherein the first lower adhesive layer contacts the display panel.

13. The display device of any one of the preceding claims, wherein the modulus of the first lower adhesive layer is different from the modulus of the cover adhesive layer.

14. The display device of any one of the preceding claims, wherein the support member further includes a resin filled in the opening.

15. The display device of any one of the preceding claims, wherein the cover adhesive layer further overlaps the flat area and is on or under the first lower adhesive layer.
